# FASCICULE DE BREVET EUROPEEN

(11) **EP 1 714 161 B1**
(45) Date de publication et mention de la délivrance du brevet: **18.04.2007**
(21) Numéro de dépôt: 04805526.3
(22) Date de dépôt: 24.11.2004
(51) Int. Cl.: G01R 1/04, G01R 15/20, H01F 38/30, H02G 15/007, H01R 13/58

(54) **ELEMENT AUXILIAIRE POUR FIXER UN CAPTEUR DE COURANT A UN CONDUCTEUR ELECTRIQUE**
HILFSELEMENT ZUM FIXIEREN EINES STROMSENSORS AN EINEM ELEKTRISCHEN LEITER
AUXILIARY ELEMENT FOR FIXING A CURRENT SENSOR TO AN ELECTRICAL CONDUCTOR

(30) Priorité: 05.12.2003 FR 0314298
(43) Date de publication de la demande: 25.10.2006
(73) Titulaire: ABB Entrelec, 69100 Villeurbanne (FR)
(72) Inventeur: VILAS BOAS, Armando, F-38230 Charvieu Chavagneux (FR)
(74) Mandataire: Laget, Jean-Loup
(86) Numéro de dépôt international: PCT/FR2004/002997
(87) Numéro de publication internationale: WO 2005/066641

(56) Documents cités:
- FR-A- 2 793 884
- US-A- 4 258 348
- US-A- 4 386 752
- US-A- 5 675 128
- PATENT ABSTRACTS OF JAPAN vol. 014, no. 451 (E-0984), 27 septembre 1990 (1990-09-27) -& JP 02 180010 A (TOSHIBA CORP), 12 juillet 1990 (1990-07-12)
- PATENT ABSTRACTS OF JAPAN vol. 006, no. 021 (E-093), 6 février 1982 (1982-02-06) -& JP 56 142614 A (U R D:KK), 7 novembre 1981 (1981-11-07)

## Description

La présente invention concerne d'une manière générale un dispositif capteur de courant destiné à mesurer la valeur du courant parcourant au moins un conducteur.

De manière connue en soi, les capteurs de courant se présentent sous la forme d'un boîtier globalement parallélépipédique renfermant les moyens de mesure du courant, ledit boîtier est traversé par une ouverture à contour fermé usuellement constituée par un manchon à travers lequel est disposé le conducteur parcouru par le courant à mesurer. Ledit boîtier de capteur de courant est adapté positionné avec ses grandes faces perpendiculaires au conducteur et à être fixé soit directement sur le conducteur, soit sur un support dans une position debout, lorsque le support est parallèle au conducteur, ou couchée, lorsque le support est perpendiculaire au conducteur.

La fixation dudit capteur en position debout est usuellement réalisée en rapportant au moins un élément auxiliaire sur le boîtier du capteur de courant. Dans le FR 99 06488, lesdits éléments auxiliaires sont constitués par des flasques ayant une face interne destinée à être appliquée contre une grande face du boîtier du capteur de courant, une face externe portant des pattes s'étendant à angle droit vers l'extérieur et dans lesquelles est formée une première paire de passage pour des premières vis de fixation. Lesdites premières vis de fixation sont destinées à assurer la fixation de l'élément auxiliaire à un support parallèle au conducteur. De part et d'autre d'une ouverture de passage destinée au positionnement du conducteur, est formée une seconde paire de passages pour la mise en place de secondes vis assurant la fixation de l'élément auxiliaire au boîtier.

D'autres moyens de fixation sont mis en oeuvre lors de la fixation du capteur de courant sur le conducteur parcouru par le courant à mesurer.

Il en résulte que l'installateur doit avoir en permanence à sa disposition différents moyens de fixation du capteur de courant lorsqu'il réalise une installation.

De plus, l'ouverture traversant le capteur de courant et destinée au passage du conducteur est habituellement dimensionnée afin d'avoir en section des dimensions proches de celles du conducteur sur lequel doit être installé le capteur. Il en résulte que des capteurs présentant des ouvertures de dimensions différentes sont proposés afin d'être choisis au coup par coup en fonction des dimensions du conducteur parcouru par le courant à mesurer.

Ces différentes dispositions usuellement mises en oeuvre obligent donc à prévoir des gammes de capteurs et d'éléments externes de fixation.

La présente invention tend à remédier à cet inconvénient en proposant un élément auxiliaire adapté à assurer les différents types de montage du capteur, sur un support ou sur le conducteur et un capteur de courant pouvant être monté sur des conducteurs de différents tailles.

A cet effet, l'invention propose un élément auxiliaire de fixation et de positionnement, à utiliser par paire pour fixer et positionner un capteur de courant par rapport à au moins un conducteur électrique parcouru par un courant à mesurer, ledit élément auxiliaire comprenant un flasque ayant une face interne destinée à être appliquée contre une grande face du capteur et une face externe qui porte, sur un premier bord, deux pattes espacées de fixation qui s'étendent à angle droit vers l'extérieur par rapport à ladite face externe et dans lesquelles est formée une première paire de passages pour des premières vis permettant la fixation de l'élément auxiliaire sur un support, ledit flasque comportant une ouverture de passage pour le conducteur électrique et, symétriquement de part et d'autre de ladite ouverture, une seconde paire de passages pour des secondes vis permettant la fixation du flasque sur le capteur, caractérisé en ce que l'ouverture de passage pour le conducteur est constituée par une échancrure formée dans un second bord du flasque opposé au premier bord, et les passages de la seconde paire de passages sont constitués par deux fentes parallèles qui s'étendent perpendiculairement au premier bord du flasque.

L'élément auxiliaire selon l'invention est encore remarquable en ce que :
- la face externe du flasque porte des graduations le long d'au moins un côté des fentes,
- les deux pattes de fixation sont réunies l'une à l'autre par une nervure courant le long du premier bord de la face externe du flasque et formée d'un seul tenant avec le flasque, ladite nervure étant apte à venir en contact avec le conducteur dans un premier mode de montage de l'élément auxiliaire sur la grande face du capteur,
- la nervure comporte en son milieu une partie concave apte à venir en contact avec une partie de la surface externe d'un câble électrique formant ledit conducteur électrique,
- l'échancrure pour le passage du conducteur comporte deux bords disposés obliquement en V et ayant un profil longitudinal en forme d'escalier,
- les profils en escalier des deux bords de l'échancrure ont des paires de parties verticales homologues, les parties verticales homologues de chaque paire étant espacées d'une distance correspondant à une largeur normalisée d'une barre conductrice servant de conducteur électrique, et des paires de parties horizontales homologues aptes à venir en contact avec une face de ladite barre conductrice dans un second mode de montage de l'élément auxiliaire sur la grande face du capteur,
- la face externe du flasque porte une paire de premières colonnettes parallèles espacées qui s'étendent le long de la face externe, perpendiculairement au premier bord de celle-ci et qui comportent chacune un trou longitudinal pour une vis de serrage,
- la face externe du flasque porte une seconde colonnette centrale qui s'étend le long de ladite face externe perpendiculairement au premier bord de celle-ci et qui comporte un trou longitudinal pour une vis de serrage.

L'invention concerne également un ensemble composé d'un capteur de courant ayant un boîtier de forme parallélépipédique avec deux grandes faces traversées par une ouverture à contour fermé, dimensionnée pour permettre le passage d'au moins un conducteur électrique ayant une section transversale présentant des dimensions comprises dans une plage prédéfinie, et de deux éléments auxiliaires pour la fixation et le positionnement du capteur par rapport audit conducteur, caractérisé en ce que chacun des deux éléments auxiliaires est un élément auxiliaire selon l'invention.

L'invention sera mieux comprise grâce à la description qui va suivre donnée à titre d'exemple non limitatif en référence aux dessins annexés dans lesquels :
- la figure 1 est une vue en perspective éclatée d'un ensemble selon l'invention composé d'un capteur de courant et de deux éléments auxiliaires,
- la figure 2 est une vue en perspective de l'ensemble de la figure 1 prêt à être fixé debout sur un support parallèle au conducteur,
- les figures 3 et 4 sont des vues en perspective montrant l'ensemble selon l'invention en cours de montage sur un conducteur formé d'une barre à la figure 3 et d'un câble à la figure 4,
- la figure 5 est une vue en perspective de l'ensemble de la figure 3 prêt à être fixé sur le conducteur,
- les figures 6 et 7 sont des vues en perspective montrant un ensemble selon l'invention respectivement en cours de montage sur un ensemble de barres et prêt à être fixé sur l'ensemble de barres,
- la figure 8 est une vue partielle agrandie de l'angle inférieur droit de l'ensemble représenté à la figure 7,
- la figure 9 est une vue partielle en coupe suivant le plan IX de la figure 8.

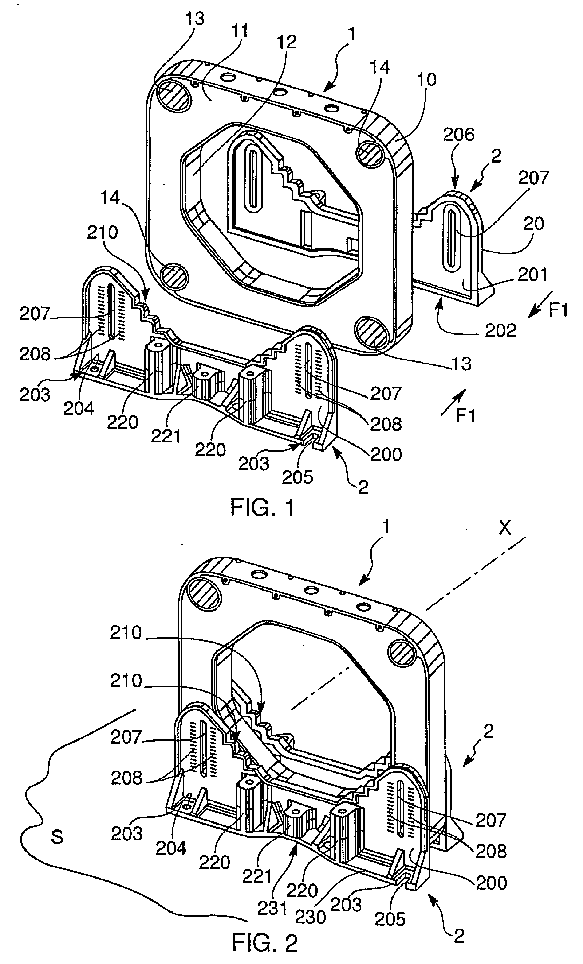

Comme visible à la figure 1, l'invention concerne un dispositif capteur de courant constitué par un ensemble comportant un capteur de courant 1 et deux éléments auxiliaires 2 de fixation et de positionnement dudit capteur 1.

A la figure 2, le conducteur parcouru par le courant à mesurer est symbolisé par son axe longitudinal X.

De manière connue en soi, le capteur de courant 1 est constitué par un boîtier 10 globalement parallélépipédique traversé perpendiculairement à ses grandes faces 11, et usuellement au centre de celles-ci, par une ouverture à contour fermé constituée par un manchon 12 cylindrique. De manière non limitative, ledit manchon 12 est de section hexagonale dans l'exemple de réalisation représenté au dessin.

Ce manchon est dimensionné pour permettre le passage d'au moins un conducteur électrique ayant une section transversale présentant des dimensions comprises dans une plage prédéfinie. Cette disposition permet avantageusement d'utiliser un capteur de courant 1 unique pour des montages autour de différents types de conducteurs, barres ou câbles, qu'ils soient seuls ou groupés, dès lors que l'encombrement total du ou desdits conducteur(s) est compris dans la plage prédéfinie.

Le boîtier 10 est traversé dans ses quatre zones de coins par des ouvertures débouchantes 13, 14 destinées au passage de vis de fixation non représentées au dessin. La mise en place de vis de fixation dans lesdites ouvertures 13, 14 permet la fixation du capteur de courant en position couchée sur un support perpendiculaire au conducteur et parallèle aux grandes faces 11 du boîtier 10.

Dans la présente description, le terme vis de fixation est utilisé pour représenter de manière large un moyen de fixation tel que un boulon (ensemble vis et écrou), une vis de type classique ou autotaraudeuse. Dans le cas où des vis sont utilisées, les ouvertures sont conformées de manière adéquate pour permettre leur serrage.

Dans l'exemple de réalisation représenté au dessin, les ouvertures débouchantes 13, 14 sont de section oblongue, les ouvertures 13 d'une part et les ouvertures 14 d'autre part ont leur grand axe alignés. La mise en oeuvre d'ouvertures de section oblongue permet de s'affranchir de défauts de parallélisme au cours du montage.

De manière connue en soi, les éléments auxiliaires 2 comprennent un flasque 20 globalement plan ayant une face interne 201 destinée à être appliquée contre une grande face 11 du capteur 1 et une face externe 200.

Lesdits éléments auxiliaires sont de préférence obtenus par moulage de matière plastique.

Le long d'un premier bord 202, le bord inférieur dans la position représentée aux figures 1 et 2, le flasque 20 porte deux pattes 203 espacées de fixation. Ces pattes 203 sont disposées à chaque extrémité dudit premier bord 202 dans l'exemple de réalisation représenté au dessin. Les pattes de fixation 203 s'étendent à angle droit vers l'extérieur par rapport à la face externe 200 du flasque 20. Lesdites pattes 203 sont traversées par une première paire de passages 204, 205 ; dans l'exemple de réalisation représenté au dessin le passage 204 a un contour fermé, de section oblongue, tandis que le passage 205 est à contour ouvert, de section allongée, et débouche dans le bord libre de la patte 203.

Cette première paire de passages 204, 205 est destinée à permettre la mise en place de premières vis de fixation non représentées au dessin afin d'assurer la fixation en position debout du capteur sur un support S parallèle au conducteur.

Selon l'invention, les deux pattes de fixation 203 sont réunies par une nervure 230 courant le long du premier bord 202 du flasque 20 ; Ladite nervure 230 comportant en son milieu une partie concave 231.

Les flasques 2 présentent encore de manière connue en soi une ouverture destinée au passage du ou des conducteur(s). Suivant l'invention, cette ouverture est une échancrure 210 pratiquée dans le second bord 206 du flasque 2, opposé au premier bord 202.

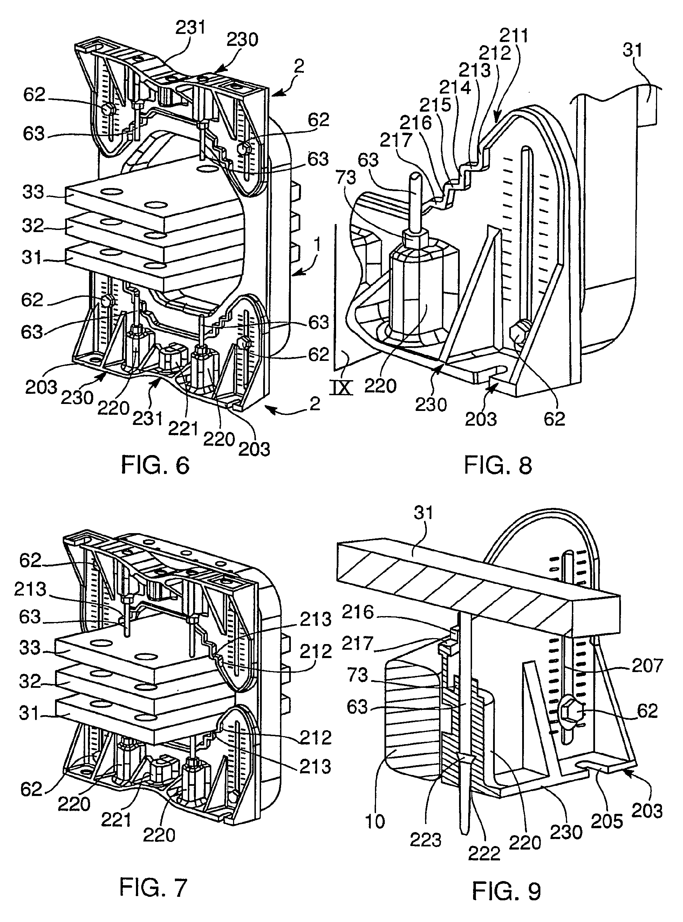

Une seconde paire de passages 207 traverse les flasques 2. Cette seconde paire de passages 207 est de manière usuelle positionnée symétriquement de part et d'autre de l'ouverture 210 et est destinée à la mise en place de secondes vis de fixation 62, figures 6 à 9, destinées à assurer la fixation d'au moins un flasque 2 au boîtier 10 du capteur de courant 1.

Suivant l'invention, les passages 207 de la seconde paire de passage sont des fentes 207 disposées parallèlement l'une à l'autre et perpendiculairement au premier bord 202 du flasque 2.

Des graduations 208 sont formées le long d'au moins un côté de chaque fente 207.

Les deux bords 211 de l'échancrure 210 sont disposés obliquement en V.

Lesdits bords obliques 211 ont un profil en forme d'escalier constitué de paires de parties verticales homologues et de paires de parties horizontales homologues, trois paires dans l'exemple de réalisation représenté au dessin, respectivement 212, 214, 216, et, 213, 215, 217.

Comme cela sera décrit en détail plus loin, ledit profil en escalier est destiné à assurer l'appui des éléments auxiliaires 2 contre des conducteurs composés par des barres conductrices. De telles barres conductrices ont usuellement une section droite de forme rectangulaire et de dimensions normalisées.

Dans les éléments auxiliaires 2 selon l'invention, les deux parties verticales 212, 214 et 216 de chaque paire de parties verticales homologues sont espacées d'une distance correspondant à une largeur normalisée de barre conductrice ; la paire de parties verticale 212 correspondant à une largeur plus importante que la paire de parties verticale 214, qui correspond elle-même à une largeur plus importante que la paire de parties verticales 216.

Le long de sa face externe 200, le flasque 20 de chaque élément auxiliaire 2 porte une paire de premières colonnettes 220 disposées perpendiculairement à la nervure 230 longeant le premier bord 202. Ces colonnettes 220 sont parallèles entre elles et espacées le long dudit bord 202. Elles sont situées de part et d'autre de la partie concave 231 de la nervure 230.

Une seconde colonnette 221, centrale, est disposée entre lesdites premières colonnettes 220, au centre de la partie concave 231. Cette colonnette centrale 221 est également perpendiculaire au premier bord 202 de l'élément auxiliaire 2.

Les trois colonnettes 220, 221 ont la même configuration, particulièrement visible pour les premières colonnettes 220 à la figure 9. Lesdites colonnettes sont traversées par un trou longitudinal 222 et un écrou 223 est noyé dans la matière plastique constituant l'élément auxiliaire 2 lors de sa fabrication. L'écrou 223 est disposé axialement dans ledit trou 222. En variante, ledit trou longitudinal 222 peut être taraudé et ne pas comporter d'écrou 223.

Des tiges filetées, ou vis, représentées en 63 pour les premières colonnettes 220 et non représentées pour la colonnette centrale 221, sont insérées dans le trou 222 en étant vissées dans l'écrou 223. Ces tiges filetées 63 portent un écrou de positionnement 73.

Comme visible aux figures 1 et 2, lors de la fixation du capteur 1 en position debout sur un support S parallèle au conducteur, deux flasques 20, positionnés de part et d'autre du boîtier 10 dudit capteur 1 avec leur face interne 201 tournée vers une grande face 11 du capteur 1, sont rapprochés dans le sens des flèches F1, de manière à être en appui contre le boîtier 10 dudit capteur 1. Des secondes vis de fixation, non représentées, sont positionnées à travers respectivement un passage 207 de la seconde paire de passages du premier flasque 20, d'une ouverture débouchante 13 ou 14 du boîtier 10 et d'un passage 207 du second flasque 20. Ces secondes vis de fixation assurent la solidarisation des flasques 20 des deux éléments auxiliaires 2 au boîtier 10 du capteur 1.

La fixation du capteur 1 en position debout est terminée par la mise en place de premières vis non représentées au dessin dans chaque passage 204, 205 de la première paire de passage formée dans les pattes de fixation 203.

Les fentes 207 permettent un déplacement relatif de chaque flasque 2 par rapport au boîtier 10 du capteur 1. Le réglage de la position relative du boîtier 10 par rapport aux éléments auxiliaires 2 est assuré en positionnant les secondes vis de fixation en regard d'une marque équivalente des graduations 208 formées le long d'au moins un côté de chaque fente 207.

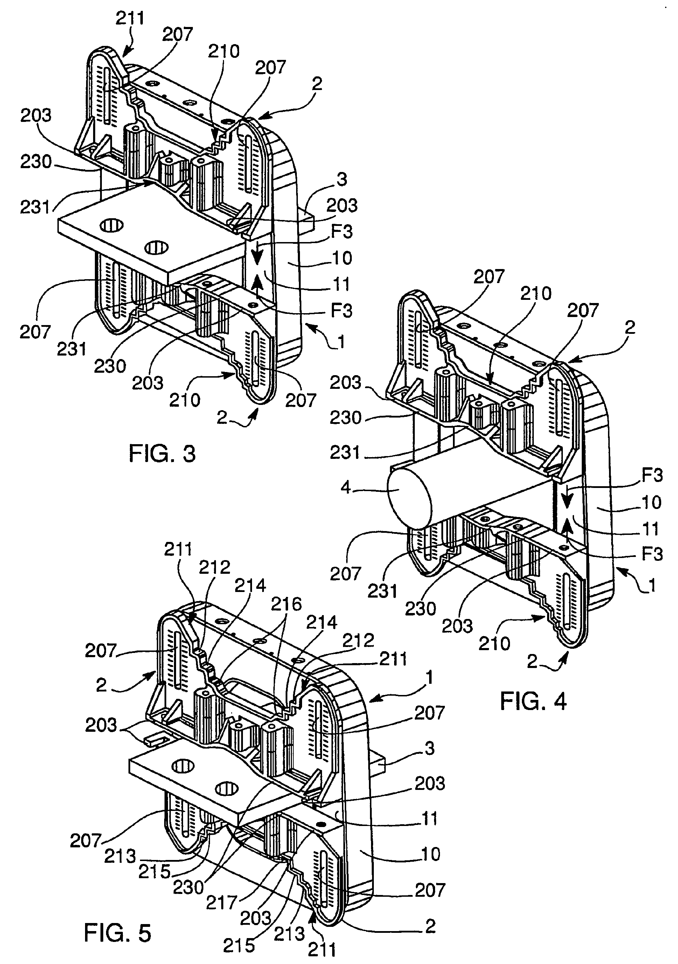

Les figures 3 à 5 montrent la fixation du capteur de courant 1 sur le conducteur parcouru par le courant à mesurer, une barre conductrice 3 aux figures 3 et 5, un câble conducteur 4 à la figure 4.

Dans ce premier mode de montage, deux éléments auxiliaires 2 selon l'invention sont disposés contre la même grande face 11 du boîtier 10 avec leurs premiers bords 202 dirigés vers le conducteur 3 ou 4 disposé dans le manchon 12 du capteur 1.

Des secondes vis de fixation sont disposées à travers les seconds passages 207 desdits éléments auxiliaires 2 et les ouvertures débouchantes 13 ou 14 du boîtier 10 sans être serrées. Les éléments auxiliaires 2 sont entraînés l'un vers l'autre dans le sens des flèches F3 jusqu'à ce que le premier bord 202 de chaque élément auxiliaire 2 soit en contact avec le conducteur.

Lorsque le conducteur est une barre 3, les nervures 230 des éléments auxiliaires 2 sont en appui contre deux faces opposées de ladite barre.

Lorsque le conducteur est un câble 4, les parties concaves 231 des éléments auxiliaires 2 sont en appui contre ledit câble en des points diamétralement opposés.

Le dispositif selon l'invention permet, grâce à la configuration en fentes des seconds passages 207 des éléments auxiliaires 2 de régler la position relative desdits éléments auxiliaires 2 par rapport au boîtier 10 du capteur 1. Il est ainsi possible, lorsque cela est nécessaire, de positionner ledit boîtier 10 de telle sorte que le conducteur 3, 4 ne soit pas centré par rapport au manchon 12.

Lorsque les éléments auxiliaires 2 sont en appui contre le conducteur 3, 4 des premières vis non représentées au dessin sont insérées dans les premiers passages 204, 205 en vis-à-vis des pattes de fixation 203 pour enserrer ledit conducteur et bloquer la position du capteur 1 par rapport audit conducteur.

Lorsque le conducteur 3, 4 est convenablement disposé par rapport au boîtier 10, les secondes vis de fixation sont serrées afin de solidariser lesdits éléments auxiliaires 2 et le boîtier 10.

Les figures 6 à 9 montrent un second mode de montage des éléments auxiliaires 2 sur le boîtier 10 du capteur 1.

Ce second mode de montage est mis en oeuvre lorsque le capteur de courant 1 doit être positionné par rapport à un ensemble de plusieurs barres conductrices 31, 32 et 33 montées parallèlement les unes aux autres. De manière connue en soi, de telles barres conductrices sont maintenues écartées les unes par rapport aux autres par des moyens indépendants non visibles au dessin.

Pour ce second mode de montage, les deux éléments auxiliaires 2 sont positionnés contre la même grande face 11 du boîtier 10 avec l'échancrure 210 tournée vers les conducteurs.

Lesdits éléments auxiliaires 2 sont rapprochés l'un de l'autre jusqu'à ce que pour chacun d'eux, l'une des paires de parties horizontales homologues 213, 215 ou 217 soit en appui contre la face externe du conducteur 31 ou 33 qui lui fait face.

Dans l'exemple de réalisation représenté au dessin, les barres conductrices 31, 32 et 33 ont la largeur normalisée correspondant à la distance séparant les deux parties de la paire de parties verticales 212 de l'échancrure 210. Les éléments auxiliaires 2 sont alors approchés l'un vers l'autre jusqu'à ce que leurs paires de parties horizontales 213 respectives soient en appui contre les faces externes des conducteurs externes 31 et 33.

Les secondes vis de fixation 62 traversant les seconds passages en fente 207 des éléments auxiliaires 2 et les ouvertures débouchantes 13, 14 du boîtier 10 sont serrées lorsque la position relative du boîtier 10 par rapport aux conducteurs 31, 32 et 33 recherchée pour le montage en cours de réalisation est obtenue.

Les tiges filetées ou vis 63 positionnées dans la paire de premières colonnettes 220 sont vissées dans l'écrou 223 jusqu'à ce que leurs extrémités soient en appui contre les faces externes des conducteurs externes 31 et 33 afin de fixer le boîtier 10 en position par rapport auxdits conducteurs.

Les moyens de vissage des tiges filetées 63 ne sont pas représentés au dessin, il est par exemple possible d'utiliser un tournevis positionné dans une rainure formée dans l'extrémité desdites tiges filetées dépassant à l'extérieur du premier bord 202 des éléments auxiliaires 2.

Pour terminer le montage, les écrous de positionnement 73 sont amenés contre les extrémités des colonnettes 220 qui font face aux conducteurs.

Les tiges filetées équipant les secondes colonnettes 221, centrales, sont mises en oeuvre dans des montages du boîtier 10 de capteur 1 sur un câble afin d'appuyer diamétralement sur celui-ci.

Comme on aura pu le comprendre à la lecture de la description ci-dessus, les éléments auxiliaires 2 selon l'invention permettent à eux seuls de réaliser tous types de montages du capteur de courant 1 sur un ou plusieurs conducteurs, que ce soit des barres ou des câbles, de manière centrée ou non.

La mise en oeuvre de l'échancrure 210 permet de plus d'adapter l'ouverture de passage réservée aux conducteurs à l'encombrement de ceux-ci.

## Revendications

1. Elément auxiliaire (2) de fixation et de positionnement, à utiliser par paire pour fixer et positionner un capteur de courant (1) par rapport à au moins un conducteur électrique (3, 4, 31, 32, 33) parcouru par un courant à mesurer, ledit élément auxiliaire (2) comprenant un flasque (20) ayant une face interne (201) destinée à être appliquée contre une grande face (11) du capteur (1) et une face externe (200) qui porte, sur un premier bord (202), deux pattes (203) espacées de fixation qui s'étendent à angle droit vers l'extérieur par rapport à ladite face externe (200) et dans lesquelles est formée une première paire de passages (204, 205) pour des premières vis permettant la fixation de l'élément auxiliaire (2) sur un support (S), ledit flasque (20) comportant une ouverture de passage (210) pour le conducteur électrique et, symétriquement de part et d'autre de ladite ouverture (210), une seconde paire de passages (207) pour des secondes vis (62) permettant la fixation du flasque (20) sur le capteur (1), **caractérisé en ce que** l'ouverture de passage (210) pour le conducteur est constituée par une échancrure (210) formée dans un second bord (206) du flasque (20) opposé au premier bord (202), et les passages de la seconde paire de passages (207) sont constitués par deux fentes parallèles qui s'étendent perpendiculairement au premier bord (202) du flasque (20).

2. Elément auxiliaire selon la revendication 1, **caractérisé en ce que** la face externe (200) du flasque (20) porte des graduations (208) le long d'au moins un côté des fentes (207).

3. Elément auxiliaire selon la revendication 1 ou selon la revendication 2, **caractérisé en ce que** les deux pattes de fixation (203) sont réunies l'une à l'autre par une nervure (230) courant le long du premier bord (202) de la face externe (200) du flasque (20) et formée d'un seul tenant avec le flasque (20), ladite nervure (230) étant apte à venir en contact avec le conducteur (3) dans un premier mode de montage de l'élément auxiliaire (2) sur la grande face (11) du capteur (1).

4. Elément auxiliaire selon la revendication 3, **caractérisé en ce que** la nervure (230) comporte en son milieu une partie concave (231) apte à venir en contact avec une partie de la surface externe d'un câble électrique (4) formant ledit conducteur électrique.

5. Elément auxiliaire selon l'une quelconque des revendications 1 à 4, **caractérisé en ce que** l'échancrure (210) pour le passage du conducteur comporté deux bords (211) disposés obliquement en V et ayant un profil longitudinal en forme d'escalier.

6. Elément auxiliaire selon la revendication 5, **caractérisé en ce que** les profils en escalier des deux bords (211) de l'échancrure (210) ont des paires de parties verticales homologues (212, 214, 216), les parties verticales homologues de chaque paire étant espacées d'une distance correspondant à une largeur normalisée d'une barre conductrice (31, 32, 33) servant de conducteur électrique, et des paires de parties horizontales homologues (213, 215, 217) aptes à venir en contact avec une face de ladite barre conductrice (31, 32, 33) dans un second mode de montage de l'élément auxiliaire (2) sur la grande face (11) du capteur (1).

7. Elément auxiliaire selon l'une quelconque des revendications 1 à 6, **caractérisé en ce que** la face externe (200) du flasque (2) porte une paire de premières colonnettes (220) parallèles espacées qui s'étendent le long de la face externe (200), perpendiculairement au premier bord (202) de celle-ci et qui comportent chacune un trou (222) longitudinal pour une vis de serrage (63).

8. Elément auxiliaire selon l'une quelconque des revendications 1 à 7, **caractérisé en ce que** la face externe (200) du flasque (20) porte une seconde colonnette (221), centrale, qui s'étend le long de ladite face externe (200) perpendiculairement au premier bord (202) de celle-ci et qui comporte un trou (222) longitudinal pour une vis de serrage.

9. Ensemble composé d'un capteur de courant (1) ayant un boîtier (10) de forme parallélépipédique avec deux grandes faces (11) traversées par une ouverture (12) à contour fermé, dimensionnée pour permettre le passage d'au moins un conducteur électrique ayant une section transversale présentant des dimensions comprises dans une plage prédéfinie, et de deux éléments auxiliaires (2) pour la fixation et le positionnement du capteur (1) par rapport audit conducteur, **caractérisé en ce que** chacun des deux éléments auxiliaires est un élément auxiliaire (2) selon l'une quelconque des revendications 1 à 8.

## Claims

1. An auxiliary fastening and positioning element (2), for use in pairs to fasten and position a current sensor (1) relative to at least one electrical conductor (3, 4, 31, 32, 33) through which a current to be measured passes, said auxiliary element (2) comprising a side plate (20) having an inner face (201) intended to be applied against a large face (11) of the sensor (1) and an outer face (200) which bears, on a first edge (202), two spaced-apart fixing lugs (203) which extend at right-angles towards the outside relative to said outer face (200) and in which there is formed a first pair of passages (204, 205) for first screws enabling the auxiliary element (2) to be fastened to a support (S), said side plate (20) comprising a passage opening (210) for the electrical conductor and, symmetrically on either side of said opening (210), a second pair of passages (207) for second screws (62) enabling the side plate (20) to be fastened to the sensor (1), **characterised in that** the passage opening (210) for the conductor is formed by a cutout (210) formed in a second edge (206) of the side plate (20) opposite the first edge (202), and the passages of the second pair of passages (207) are formed by two parallel slots which extend perpendicular to the first edge (202) of the side plate (20).

2. An auxiliary element according to Claim 1, **characterised in that** the outer face (200) of the side plate (20) bears graduations (208) along at least one side of the slots (207).

3. An auxiliary element according to Claim 1 or according to Claim 2,
**characterised in that** the two fixing lugs (203) are joined to one another by a rib (230) running along the first edge (202) of the outer face (200) of the side plate (20) and formed in a single piece with the side plate (20), said rib (230) being capable of coming into contact with the conductor (3) in a first mode of assembly of the auxiliary element (2) on the large face (11) of the sensor (1).

4. An auxiliary element according to Claim 3, **characterised in that** the rib (230) comprises in its centre a concave part (231) capable of coming into contact with part of the outer surface of an electric cable (4) forming said electrical conductor.

5. An auxiliary element according to any one of Claims 1 to 4, **characterised in that** the cutout (210) for the conductor to pass through comprises two edges (211) arranged obliquely in a V and having a stepped longitudinal profile.

6. An auxiliary element according to Claim 5, **characterised in that** the stepped profiles of the two edges (211) of the cutout (210) have pairs of homologous vertical parts (212, 214, 216), the homologous vertical parts of each pair being spaced apart by a distance corresponding to a standardised width of a conducting bar (31, 32, 33) which acts as an electrical conductor, and pairs of homologous horizontal parts (213, 215, 217) capable of coming into contact with a face of said conducting bar (31, 32, 33) in a second mode of assembly of the auxiliary element (2) on the large face (11) of the sensor (1).

7. An auxiliary element according to any one of Claims 1 to 6, **characterised in that** the outer face (200) of the side plate (2) bears a pair of first, spaced-apart, parallel pillars (220) which extend along the outer face (200), perpendicular to the first edge (202) thereof and which each comprise a longitudinal hole (222) for a clamping screw (63).

8. An auxiliary element according to any one of Claims 1 to 7, **characterised in that** the outer face (200) of the side plate (20) bears a second, central, pillar (221), which extends along said outer face (200), perpendicular to the first edge (202) thereof and which comprises a longitudinal hole (222) for a clamping screw.

9. An assembly formed of a current sensor (1) having a casing (10) of parallelepipedal form with two large faces (11) through which an opening (12) of closed contour passes which is sized to enable at least one electrical conductor having a cross-section which has dimensions which lie within a predefined range to pass through, and of two auxiliary elements (2) for fastening and positioning the sensor (1) relative to said conductor, **characterised in that** each of the two auxiliary elements is an auxiliary element (2) according to any one of Claims 1 to 8.

## Patentansprüche

1. Hilfselement (2) zur Fixierung und Positionierung, für paarweise Verwendung zum Fixieren und Positionieren eines Stromsensors (1) relativ zu mindestens einem elektrischen Leiter (3, 4, 31, 32, 33), durch den ein zu messender Strom fliest, wobei das Hilfselement (2) einen Flansch (20) aufweist mit einer Innenfläche (201), die zur Anlage gegen eine große Fläche (11) des Sensors (1) bestimmt ist, und mit einer Außenfläche (200), die auf einem ersten Rand (202) zwei voneinander beabstandete Befestigungslappen (203) trägt, die sich bezüglich der Außenfläche (200) im rechten Winkel nach außen erstrecken und in denen ein erstes Paar von Durchlässen (204, 205) für erste Schrauben geformt ist, die die Befestigung des Hilfselements (2) auf einem Träger (S) ermöglichen, wobei der Flansch (20) eine Durchgangsöffnung (210) für den elektrischen Leiter sowie, symmetrisch beiderseits dieser Öffnung (210), ein zweites Paar von Durchlässen (207) für zweite Schrauben (62) aufweist, die die Befestigung des Flansches (20) auf dem Sensor (1) ermöglichen, **dadurch *gekennzeichnet,* dass** die Durchgangsöffnung (210) für den Leiter von einem Ausschnitt (210) gebildet wird, der in einem zweiten Rand (206) des Flansches (20), der dem ersten Rand (202) gegenüberliegt, geformt ist, und dass die Durchlässe des zweiten Paares von Durchlässen (207) aus zwei parallelen Schlitzen bestehen, die sich rechtwinkelig zu dem ersten Rand (202) des Flansches (20) erstrecken.

2. Hilfselement nach Anspruch 1, **dadurch *gekennzeichnet,* dass** die Außenfläche (200) des Flansches (20) Stricheinteilungen (208) entlang mindestens einer Seite der Schlitze (207) trägt.

3. Hilfselement nach Anspruch 1 oder Anspruch 2, **dadurch *gekennzeichnet,* dass** die beiden Befestigungslappen (203) miteinander durch eine Rippe (230) verbunden sind, die entlang dem ersten Rand (202) der Außenfläche (200) des Flansches (20) verläuft und einstückig mit dem Flansch (20) ausgebildet ist, wobei die Rippe (230) dazu geeignet ist, in einem ersten Montagemodus des Hilfselements (2) an der großen Fläche (11) des Sensors (1) in Kontakt mit dem Leiter (3) zu kommen.

4. Hilfselement nach Anspruch 3, **dadurch *gekennzeichnet,* dass** die Rippe (230) in ihrer Mitte einen konkaven Bereich (231) aufweist, der geeignet ist, mit einem Teil der Außenfläche eines den elektrischen Leiter bildenden elektrischen Kabels (4) in Kontakt zu kommen.

5. Hilfselement nach einem der Ansprüche 1 bis 4, **dadurch *gekennzeichnet,* dass** der Ausschnitt (210) für den Durchgang des Leiters zwei Ränder (211) aufweist, die schräg V-förmig angeordnet sind und ein treppenförmiges Längsprofil haben.

6. Hilfselement nach Anspruch 5, **dadurch *gekennzeichnet,* dass** die treppenförmigen Profile der beiden Ränder (211) des Ausschnitts (210) Paare voneinander entsprechenden vertikalen Abschnitten (212, 214, 216) aufweisen, wobei die einander entsprechenden vertikalen Abschnitte jedes Paares voneinander einen Abstand haben, der einer Normbreite einer Leiterschiene (31, 32, 33), die als elektrischer Leiter dient, entspricht, und wobei Paare von einander entsprechenden horizontalen Abschnitten (213, 215, 217) geeignet sind, in einem zweiten Befestigungsmodus des Hilfselementes (2) auf der großen Fläche (11) des Sensors (1) in Kontakt mit einer Fläche der Leiterschiene (31, 32, 33) zu kommen.

7. Hilfselement nach einem der Ansprüche 1 bis 6, **dadurch *gekennzeichnet,* dass** die Außenfläche (200) des Flansches (2) ein Paar von ersten parallelen, voneinander beabstandeten Säulen (220) trägt, die sich längs der Außenfläche (200) rechtwinkelig zu deren erstem Rand (202) erstrecken und jeweils eine Längsbohrung (222) für eine Spannschraube aufweisen.

8. Hilfselement nach einem der Ansprüche 1 bis 7, **dadurch *gekennzeichnet,* dass** die Außenfläche (200) des Flansches (20) eine zweite mittlere Säule (221) aufweist, die sich längs der Außenfläche (200) rechtwinkelig zu deren ersten Rand (202) erstreckt und eine Längsbohrung (222) für eine Spannschraube aufweist.

9. Zusammengesetzte Anordnung aus einem Stromsensor (1) mit einem Gehäuse (10) von Quaderform mit zwei großen Flächen (11), durch die sich eine Öffnung (12) mit geschlossener Kontur erstreckt, deren Abmessungen den Durchtritt mindestens eines elektrischen Leiters erlauben, der einen Querschnitt mit Abmessungen in einem vorgegebenen Bereich aufweist, und aus zwei Hilfselementen (2) für die Fixierung und Positionierung des Sensors (1) relativ zu dem Leiter, **dadurch *gekennzeichnet,* dass** jedes der beiden Hilfselemente ein Hilfselement (2) gemäß einem der Ansprüche 1 bis 8 ist.
